(19) **Europäisches Patentamt / European Patent Office / Office européen des brevets**

(11) **EP 2 476 209 B1**

(12) # FASCICULE DE BREVET EUROPEEN

(45) Date de publication et mention
de la délivrance du brevet:
**14.01.2015 Bulletin 2015/03**

(21) Numéro de dépôt: **10747641.8**

(22) Date de dépôt: **01.09.2010**

(51) Int Cl.:
*H03H 7/40* (2006.01)          *H03F 1/56* (2006.01)
*H03F 3/24* (2006.01)

(86) Numéro de dépôt international:
**PCT/EP2010/062791**

(87) Numéro de publication internationale:
**WO 2011/026858 (10.03.2011 Gazette 2011/10)**

(54) **PROCEDE D'ADAPTATION D'IMPEDANCE D'ANTENNE MULTIBANDES ET CHAÎNE D'EMISSION OU RECEPTION A ADAPTATION AUTOMATIQUE**

IMPEDANZABGLEICHSVERFAHREN FÜR EINE MEHRFREQUENZANTENNNE UND ÜBERTRAGUNGS- ODER EMPFANGSKANAL MIT AUTOMATISCHEM ABGLEICH

IMPEDANCE MATCHING METHOD FOR A MULTI-BAND ANTENNA, AND TRANSMISSION OR RECEPTION CHANNEL HAVING AUTOMATIC MATCHING

(84) Etats contractants désignés:
**AL AT BE BG CH CY CZ DE DK EE ES FI FR GB GR HR HU IE IS IT LI LT LU LV MC MK MT NL NO PL PT RO SE SI SK SM TR**

(30) Priorité: **07.09.2009 FR 0956063**

(43) Date de publication de la demande:
**18.07.2012 Bulletin 2012/29**

(73) Titulaire: **Commissariat à l'Énergie Atomique et aux Énergies Alternatives 75015 Paris (FR)**

(72) Inventeurs:
• **CHAN WAI PO, Francis
  F-38100 Grenoble (FR)**
• **DE FOUCAULD, Emeric
  F-38170 Seyssinet (FR)**

(74) Mandataire: **Guérin, Michel
  Marks & Clerk France
  Conseils en Propriété Industrielle
  Immeuble Visium
  22, Avenue Aristide Briand
  94117 Arcueil Cedex (FR)**

(56) Documents cités:
**FR-A1- 2 573 940     US-A1- 2009 066 440**

## Description

L'invention concerne un circuit d'adaptation automatique d'impédance d'antenne radio et le procédé d'adaptation correspondant.

Dans certaines applications de transmission d'informations en radiofréquence, on a constaté que l'antenne d'émission ou de réception pouvait avoir une impédance dépendant fortement de conditions extérieures à l'antenne, et dépendant notamment du milieu dans lequel l'antenne est placée.

Par exemple, dans la télémétrie médicale, on peut être amené à introduire l'antenne dans une sonde placée dans le corps humain, et l'impédance dépend alors fortement du milieu biologique dans lequel l'antenne se trouve. Elle dépend des propriétés électriques (conductivité, constante diélectrique) des tissus environnants (muscles, graisse) ou du milieu liquide (sang, autres liquides) dans lequel l'antenne peut être immergée.

Même dans des applications plus conventionnelles de transmission radiofréquence (téléphonie mobile, etc.) l'impédance de l'antenne peut varier.

Une chaîne d'émission (respectivement de réception) comprend au moins un amplificateur auquel peuvent être associés un ou plusieurs filtres.

De manière générale, les variations d'impédance d'antenne sont particulièrement sensibles pour des antennes de très petites dimensions ayant un fort coefficient de qualité, utilisées dans les applications à fortes contraintes de miniaturisation.

Ces variations d'impédance peuvent entraîner des pertes dites pertes de désadaptation : ces pertes résultent de ce que la chaîne d'émission qui alimente l'antenne, ou la chaîne de réception qui reçoit un signal de l'antenne, est en général conçue pour avoir des performances optimales lorsqu'elle est chargée (en sortie pour la chaîne d'émission ou en entrée pour la chaîne de réception) par une impédance nominale bien déterminée ; elle a des performances dégradées lorsqu'elle est chargée par une impédance différente de sa valeur nominale. Les pertes de désadaptation peuvent aller jusqu'à 40 dB.

C'est pourquoi on a déjà essayé d'interposer entre la sortie de la chaîne d'émission et l'antenne d'émission (et on pourrait le faire aussi en entrée pour une antenne de réception) un réseau d'adaptation d'impédance, en anglais « matching network », qui fait que la chaîne d'émission voit une impédance différente de celle de l'antenne et de préférence égale à la valeur nominale pour laquelle elle a été conçue, par exemple 100 ohms ou 500 ohms. Le réseau d'adaptation est accordable, c'est-à-dire que ses éléments, capacitifs et/ou inductifs, ont des valeurs ajustables pour tenir compte des conditions d'environnement de l'antenne de telle sorte que l'adaptation soit la meilleure possible quelles que soient les circonstances.

Dans la technique antérieure illustrée par le brevet US 4 375 051, on a proposé d'utiliser un coupleur bidirectionnel pour détecter une désadaptation : la puissance de l'amplificateur est appliquée à une charge par l'intermédiaire du coupleur et d'un réseau d'adaptation d'impédance ; si l'ensemble est désadapté, une partie de la puissance envoyée à l'antenne est réfléchie par celle-ci au lieu d'être envoyée dans le milieu environnant ; la partie réfléchie repasse dans le coupleur et en sort par une sortie spécifique ; la puissance de sortie réfléchie est détectée, mesurée, et sert à asservir le réseau d'impédance pour modifier sa constitution dans un sens tendant à réduire la puissance réfléchie. Le réseau d'adaptation comprend des condensateurs variables. La commande du réseau peut se faire par un asservissement à base de circuits matériels ou à base d'un algorithme de calcul.

Ce procédé est itératif, lent, et consommateur de puissance. L'utilisation d'un coupleur rend le circuit d'adaptation non intégrable dans une puce de circuit intégré compte-tenu de l'encombrement du coupleur.

Dans la demande de brevet US 2009-0066440, on a par ailleurs proposé un procédé d'adaptation automatique d'impédance dans une chaîne d'émission ou de réception, dans lequel on détecte à la fois l'amplitude et la phase du courant et de la tension en sortie de la chaîne d'émission (ou en entrée de la chaîne de réception). Le rapport entre la tension et le courant est représentatif de l'impédance de charge Zm vue par la chaîne chargée par l'ensemble du réseau d'adaptation et de l'antenne d'impédance $Z_{ant}$. On mesure l'impédance de charge Zm et on calcule l'impédance d'antenne $Z_{ant}$ à partir de l'impédance de charge mesurée Zm et des impédances du réseau d'adaptation dont la configuration est connue au moment de la mesure, et enfin on calcule la modification qu'il faut appliquer à une ou plusieurs des impédances du réseau d'adaptation, pour obtenir que l'impédance vue par l'amplificateur devienne adaptée à l'impédance nominale de l'amplificateur dans les conditions actuelles d'environnement de l'antenne.

Mais le circuit décrit dans cette demande de brevet est conçu pour fonctionner à une fréquence radio bien déterminée et il ne permet pas de fonctionner de manière correcte si on modifie la fréquence de fonctionnement de la chaîne.

Selon l'invention, on propose une chaîne d'émission ou de réception comportant des moyens d'adaptation automatique d'impédance, ainsi qu'un procédé d'adaptation automatique d'impédance, qui peuvent fonctionner dans plusieurs bandes de fréquence différentes et qui sont donc adaptables à plusieurs applications possibles fonctionnant à des fréquences différentes.

Le procédé selon l'invention est un procédé d'adaptation automatique d'impédance pour une chaîne d'émission radiofréquence comprenant au moins un amplificateur, une antenne, un processeur de calcul, et un réseau d'adaptation d'impédance entre l'amplificateur et l'antenne, ce réseau comprenant plusieurs impédances dont certaines ont des valeurs numériques ajustables, l'amplificateur ayant une impédance de charge nominale pour laquelle la chaîne a des performances désirées, et le procédé comprenant les étapes suivantes :

- mesure du courant et de la tension de sortie de l'amplificateur,
- calcul de l'impédance complexe définie par le rapport entre cette tension et ce courant en tenant compte de leur déphasage, cette impédance représentant une impédance de charge actuelle de l'amplificateur,
- calcul de l'impédance de l'antenne en fonction de cette impédance de charge actuelle et en fonction des valeurs actuelles connues des impédances ajustables du réseau d'adaptation,
- calcul de nouvelles valeurs d'impédances ajustables du réseau d'adaptation qui permettent d'obtenir une impédance de charge globale de l'amplificateur aussi proche que possible de l'impédance de charge nominale, à partir de la valeur d'impédance d'antenne calculée,
- commande du réseau d'adaptation pour ajuster les impédances ajustables à ces nouvelles valeurs.

Le procédé est caractérisé en ce que le courant est mesuré au moyen d'une impédance de mesure variable placée en série entre la sortie de l'amplificateur et le réseau d'adaptation d'impédance, et cette impédance de mesure est commandée par le processeur en fonction de la fréquence de travail et de l'impédance de charge nominale de l'amplificateur.

L'impédance de mesure variable est donc commandable par le processeur de calcul, de sorte qu'on peut changer sa valeur, et sa valeur est connue du processeur de calcul car elle intervient dans le calcul du réseau d'adaptation.

Et symétriquement, pour un circuit de réception radiofréquence, l'invention propose un procédé d'adaptation automatique d'impédance pour une chaîne de réception radiofréquence comprenant au moins un amplificateur, une antenne, un processeur de calcul, et un réseau d'adaptation d'impédance entre l'antenne et l'amplificateur, ce réseau comprenant plusieurs impédances dont certaines ont des valeurs numériques ajustables, la chaîne de réception ayant des performances désirées lorsqu'une impédance d'entrée nominale est connectée l'entrée de l'amplificateur, le procédé comprenant les étapes suivantes :

- mesure du courant et de la tension en entrée de l'amplificateur,
- calcul de l'impédance complexe définie par le rapport entre cette tension et ce courant en tenant compte de leur déphasage, cette impédance représentant une impédance d'entrée actuellement connectée à l'amplificateur,
- calcul de l'impédance de l'antenne en fonction de cette impédance d'entrée actuelle et en fonction des valeurs actuelles connues des impédances ajustables du réseau d'adaptation,
- calcul de nouvelles valeurs d'impédances ajustables du réseau d'adaptation qui permettent d'obtenir une impédance d'entrée globale de l'amplificateur aussi proche que possible de l'impédance d'entrée nominale, à partir de la valeur d'impédance d'antenne calculée,
- commande du réseau d'adaptation pour ajuster les impédances ajustables à ces nouvelles valeurs.

Le procédé est caractérisé en ce que le courant est mesuré au moyen d'une impédance de mesure variable placée en série entre le réseau d'adaptation d'impédance et l'amplificateur, et cette impédance de mesure est commandée par le processeur en fonction de la fréquence de travail et de l'impédance d'entrée nominale de l'amplificateur.

Pour un circuit radiofréquence fonctionnant à la fois en émission et en réception avec une seule antenne d'émission-réception et ayant donc un amplificateur d'émission et un amplificateur de réception, on peut prévoir deux réseaux d'adaptation distincts, l'un pour adapter la charge en sortie de l'amplificateur d'émission, l'autre pour adapter la charge en entrée de l'amplificateur de réception.

L'impédance de mesure peut être une simple capacité.

Selon l'invention, on utilise de préférence un procédé de calcul particulièrement avantageux pour calculer de nouvelles valeurs d'impédances ajustables du réseau d'adaptation. Ce procédé peut être résumé de la manière suivante : le réseau d'adaptation est un réseau en Pi comprenant une admittance réactive d'entrée, une impédance réactive de liaison, et une admittance réactive de sortie ; le calcul des éléments de ce réseau d'adaptation comprend successivement

- un calcul de partie réelle y2r et partie imaginaire y2i d'une admittance y2 qui est l'inverse de l'impédance ($Z_{ant}$) de l'antenne,
- un calcul de partie réelle y1r et partie imaginaire y1i d'une admittance y1 qui est l'inverse de l'impédance de l'ensemble en série de l'impédance de sortie de l'amplificateur et de l'impédance de mesure,
- le calcul d'un réseau fictif comprenant un montage en Pi d'une admittance réactive d'entrée, d'une admittance réactive de sortie, et d'une impédance réactive de liaison égale à celle du réseau réel, ce montage en Pi étant placé entre deux admittances réelles qui sont les parties réelles y1r et y2r, et le calcul étant une détermination des admittances réactives d'entrée et de sortie qu'il faut dans le réseau fictif pour adapter l'impédance de ce réseau chargé par y2r à l'impédance d'entrée réelle y1 r,
- et enfin après calcul des admittances réactives d'entrée et de sortie du réseau fictif, une détermination d'admittances du réseau d'adaptation de la manière suivante :

- l'admittance réactive d'entrée du réseau d'adaptation est la différence entre l'admittance d'entrée du réseau fictif et la partie imaginaire y1i,
- l'admittance réactive de sortie est la différence entre l'admittance de sortie du réseau fictif et la partie imaginaire y2i,
- l'impédance réactive de liaison est celle du réseau fictif.

L'invention concerne également une chaîne d'émission ou de réception radiofréquence comportant au moins un amplificateur, une antenne, un processeur de calcul, et un réseau d'adaptation d'impédance entre l'amplificateur et l'antenne, ce réseau comprenant plusieurs impédances dont certaines ont des valeurs numériques ajustables, la chaîne comportant :

- une impédance de mesure insérée en série entre l'amplificateur et le réseau d'adaptation,
- des moyens de mesure d'une première tension qui est la tension aux bornes de l'impédance de mesure et d'une deuxième tension qui est la tension en sortie de l'amplificateur (pour une chaîne d'émission) ou la tension en entrée de l'amplificateur (pour une chaîne de réception),
- des premiers moyens de programmation du processeur de calcul pour calculer l'impédance complexe de charge ou d'entrée actuelle de l'amplificateur à partir du rapport entre la deuxième tension et la première tension, en tenant compte du déphasage entre ces tensions,
- des deuxièmes moyens de programmation du processeur de calcul pour calculer l'impédance de l'antenne en fonction de cette impédance de charge ou d'entrée actuelle et en fonction des valeurs actuelles connues des impédances ajustables du réseau d'adaptation,
- des troisièmes moyens de programmation du processeur de calcul pour calculer des nouvelles valeurs d'impédance ajustables du réseau d'adaptation qui permettent d'obtenir une impédance de charge ou d'entrée globale de l'amplificateur aussi proche que possible d'une impédance de charge ou d'entrée nominale de l'amplificateur, à partir de la valeur d'impédance d'antenne calculée,
- des moyens de commande électrique du réseau d'adaptation pour ajuster les impédances ajustables à ces nouvelles valeurs.

La chaîne est caractérisée en ce que l'impédance de mesure est une impédance complexe variable, le processeur de calcul comprend des moyens pour sélectionner une valeur souhaitée pour l'impédance de mesure, en fonction de la fréquence de travail souhaitée et de la valeur de l'impédance de charge ou d'entrée nominale de la chaîne, et la chaîne comprend des moyens pour attribuer cette valeur sélectionnée à l'impédance de mesure.

Le réseau d'adaptation peut être constitué d'un montage simple à trois impédances réactives en Té ou en Pi, par exemple une capacité et deux inductances ou mieux une inductance et deux capacités. Au moins une de ces impédances est variable mais en pratique deux des impédances seront variables. De préférence on utilisera deux capacités variables et une inductance fixe en considérant qu'il est plus facile de réaliser des capacités variables précises que des inductances variables. Le réseau d'adaptation peut aussi avoir plusieurs étages en cascade si la désadaptation risque d'être particulièrement forte. Dans ce cas, chaque étage peut être constitué par un montage simple à trois impédances réactives en Té ou en Pi avec en principe deux impédances réactives variables dans chaque étage.

Les impédances variables, impédance de mesure ou impédances du réseau d'adaptation, peuvent être réalisées sous forme de plusieurs impédances élémentaires en série et/ou en parallèle, individuellement commutables par une commande électronique. Une capacité variable peut aussi être réalisée par un élément commandable par une tension électrique (diode varactor par exemple).

La valeur donnée à l'impédance de mesure par le processeur de calcul est de préférence l'impédance d'une capacité de valeur C comprise entre 1 fois et 4 fois le rapport $1/Z_{opt}\omega$, où $Z_{opt}$ est l'impédance nominale de la chaîne, et $\omega$ est $2\pi f$, f étant la fréquence de travail désirée pour la chaîne. Une valeur préférentielle est $C= 2/Z_{opt}\omega$. Si l'impédance de mesure peut varier selon des valeurs discrètes, on choisira la valeur de capacité la plus proche de cette valeur optimale. C'est le cas par exemple si la capacité variable est formée d'un groupe de plusieurs capacités commutables mises en parallèle.

Le but de l'invention est d'obtenir idéalement une impédance de charge ou d'entrée globale de l'amplificateur égale à l'impédance d'entrée ou de charge nominale de l'amplificateur, mais la précision de réglage des éléments ajustables du réseau d'adaptation n'est pas infinie et on cherchera donc en pratique à s'approcher autant que possible de cette impédance nominale.

D'autres caractéristiques et avantages de l'invention apparaîtront à la lecture de la description détaillée qui suit et qui est faite en référence aux dessins annexés dans lesquels :

- la figure 1 représente la constitution générale d'un circuit d'émission radiofréquence comportant des moyens d'adaptation automatique d'impédance selon l'invention ;
- la figure 2 représente un diagramme de principe des principales étapes du procédé selon l'invention ;
- la figure 3 représente un exemple de réseau d'adaptation d'impédance simple, en Pi, avec deux capacités variables ;
- la figure 4 et la figure 5 représentent les transformations du réseau d'adaptation pour un calcul plus simple de l'adaptation.

Dans la description détaillée qui suit, on considérera systématiquement que l'antenne est une antenne d'émission alimentée par la sortie d'un amplificateur qui est conçu pour fonctionner de manière optimale lorsque la charge placée à sa sortie a une impédance nominale $Z_{opt}$ et lorsque la fréquence de fonctionnement est f, correspondant à une pulsation $\omega = 2\pi.f$. A haute fréquence, l'impédance $Z_{opt}$ sera généralement complexe. Mais l'invention est applicable de la même manière si l'antenne est une antenne de réception connectée à l'entrée d'un amplificateur conçu pour fonctionner de manière optimale lorsque l'impédance connectée à son entrée est une impédance nominale $Z_{opt}$ et lorsque la fréquence de fonctionnement est f. Si l'antenne doit fonctionner à la fois en émission et en réception, l'amplificateur d'émission aura de préférence une impédance de charge nominale égale à l'impédance d'entrée nominale de l'amplificateur de réception. Si ce n'est pas le cas, l'amplificateur d'émission et l'amplificateur de réception seront associés à deux réseaux d'adaptation distincts, l'un adaptant la charge de sortie de l'amplificateur d'émission, l'autre adaptant la charge d'entrée de l'amplificateur de réception. La méthode étant la même pour l'émission et la réception et les calculs étant également les mêmes on décrira l'invention seulement à propos de l'amplificateur et l'antenne d'émission.

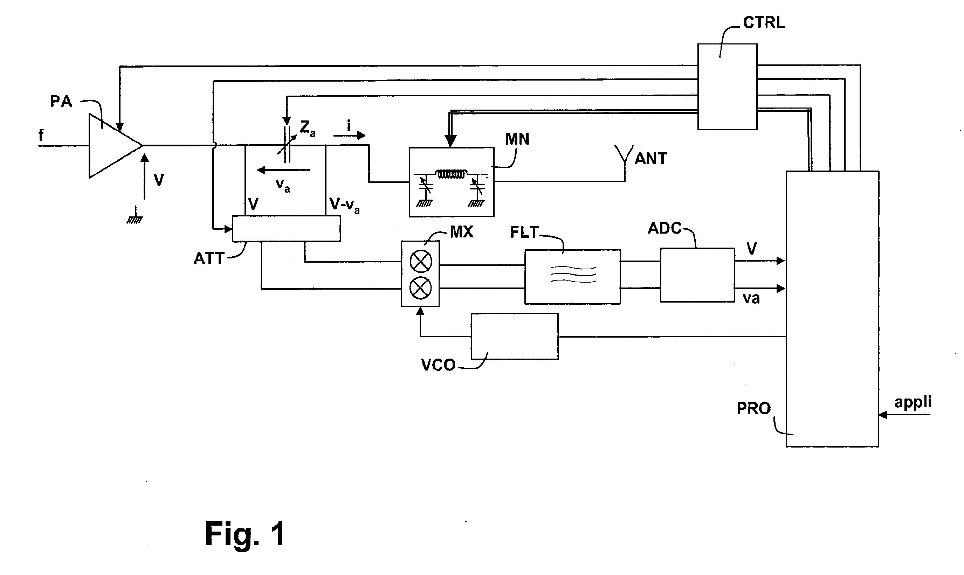

La figure 1 représente le schéma de principe du circuit d'émission radiofréquence selon l'invention, avec un amplificateur PA travaillant à la fréquence porteuse d'émission f, une antenne ANT alimentée par l'amplificateur, un réseau d'adaptation MN inséré en série entre la sortie de l'amplificateur PA et l'antenne ANT. Ce schéma pourrait aussi inclure un filtre entre l'amplificateur PA et le réseau MN et/ou un filtre entre le réseau MN et l'antenne.

Une impédance de mesure Za, de valeur variable, est insérée entre la sortie de l'amplificateur et le réseau d'adaptation d'impédance MN. L'impédance $Z_a$ sert à la mesure du courant i qui sort de l'amplificateur. L'impédance $Z_a$ est de préférence une simple capacité de valeur $C_a$ et d'impédance $Z_a = 1/j.C_a.\omega$. La tension à ses bornes est une tension $v_a$ égale à $Z_a.i$, ou encore $v_a = i/j.C_a.\omega$. La tension de sortie de l'amplificateur, qui alimente le réseau MN et l'antenne ANT est une tension V. L'impédance vue par la sortie de l'amplificateur est donc une impédance Z égale à V/i. Si on mesure V et i en amplitude et en phase, on peut déterminer une valeur actuelle mesurée, Zm, de l'impédance Z vue par l'amplificateur. La valeur Zm est une valeur complexe, avec une partie réelle et une partie imaginaire, à partir du moment où on prend en compte le déphasage entre le courant i et la tension V. Le courant i est déterminé par la mesure de $v_a$, connaissant $Z_a$.

La mesure de la tension V et la mesure de la tension $v_a$ sont faites de préférence après conversion de la fréquence f à une fréquence intermédiaire plus basse, ou en bande de base. Cela permet d'améliorer la précision du calcul, et dans le cas général on peut utiliser des éléments de circuit (mélangeur, oscillateurs locaux) qui sont de toutes façons présents dans la chaîne d'émission ou de réception.

Les tensions V et $v_a$ sont de préférence atténuées par un atténuateur variable ATT qui ramène ces tensions à un niveau qui les place dans la plage de linéarité de fonctionnement des mélangeurs MX qui servent à convertir la fréquence f à une fréquence intermédiaire.

Les mélangeurs MX reçoivent les tensions V et $v_a$ (ou V et $V-v_a$ ce qui revient au même) ainsi qu'une fréquence locale destinée à faire la conversion à une fréquence intermédiaire. La fréquence locale est fournie par un oscillateur VCO commandé par une tension ou une boucle à asservissement de phase comprenant un oscillateur commandé par une tension ; la valeur de la fréquence locale dépend à la fois de la fréquence de travail et de la fréquence intermédiaire à laquelle on veut ramener la fréquence de travail pour faire la mesure de V et $v_a$.

Les mélangeurs peuvent être suivis de filtres FLT destinés à éliminer les fréquences indésirables en sortie des mélangeurs. Les tensions de sortie de ces filtres sont converties en numérique par des convertisseurs analogiques-numériques (ADC) qui fournissent des valeurs représentant les tensions V (tension de sortie de l'amplificateur) et $v_a$ (tension mesurée aux bornes de l'impédance variable $Z_a$).

Un processeur PRO (processeur dédié ou microprocesseur programmé) reçoit les valeurs numériques ainsi mesurées. Ce processeur comporte les moyens de calcul (programmes) permettant le fonctionnement du circuit, et permettant notamment :

- le calcul d'une valeur souhaitée pour l'impédance $Z_a$ (ou en pratique d'une valeur de capacité $C_a$) en fonction de l'application ; ce calcul repose notamment sur la connaissance de la fréquence utilisée par l'application, ainsi que de l'impédance optimale de charge (dans le cas d'une chaîne d'émission) ou d'entrée (dans le cas d'une chaîne de réception) de l'amplificateur ;
- le calcul des valeurs d'impédance qu'il faut attribuer aux éléments du réseau d'adaptation d'impédance MN ; ce calcul repose sur les mesures de V et $v_a$ fournies par les convertisseurs analogique-numérique et sur la valeur de l'impédance $Z_a$ imposée par le calcul précédent ; il passe par un calcul de l'impédance mesurée Zm, en module et argument ou en partie réelle et partie imaginaire, en sortie de l'amplificateur (ou en entrée).

Le processeur PRO commande un circuit de contrôle CTRL qui permet d'imposer à la capacité $C_a$ (ou plus généralement à l'impédance de mesure $Z_a$) la valeur déterminée par le processeur et d'imposer au réseau MN les valeurs d'impédance déterminées par le processeur.

Pour pouvoir faire des calculs qui prennent en compte la nature de l'application (valeur de fréquence de travail, impédance optimale), le processeur comprend par exemple une entrée (entrée désignée par "appli" sur la figure 1) recevant une information sur l'application. Cette entrée peut être par exemple une entrée multiple sur laquelle sont rentrées différentes données relatives à l'application, ou une entrée simple recevant seulement une identification de l'application, les données de fréquence et impédance optimale étant alors contenues dans une table interne du processeur ; l'identification de l'application sert à accéder aux informations dans la table.

De préférence, le processeur comporte aussi des moyens pour déterminer une valeur d'atténuation et le circuit de contrôle CTRL commande l'atténuateur ATT pour qu'il établisse cette atténuation. Le calcul de l'atténuation souhaitée repose sur la valeur de la puissance nominale de l'amplificateur ; celle-ci dépend de l'application et, si le circuit doit pouvoir fonctionner pour plusieurs applications différentes à puissances différentes, le processeur doit recevoir une information sur la puissance nominale désirée dans l'application. Cette information de puissance de l'amplificateur est rentrée, comme les informations de fréquence et d'impédance optimale, par l'entrée "appli", ou bien elle est contenue dans la table interne du processeur. Le but de l'atténuation est d'éviter d'appliquer une puissance trop importante aux mélangeurs, ce qui risquerait de les faire sortir de leur place de linéarité.

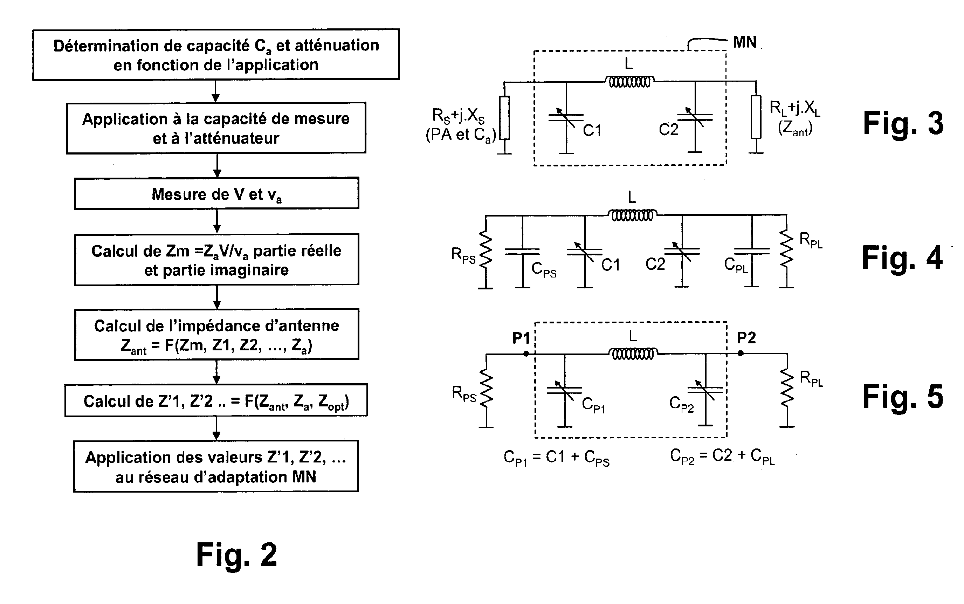

Le procédé selon l'invention est résumé dans l'organigramme de la figure 2 et comprend les grandes étapes suivantes :

- calcul de la valeur qu'il faut donner à l'impédance $Z_a$ (par exemple calcul de la valeur d'une capacité $C_a$, en fonction de l'application) ; ce calcul peut consister en une simple sélection d'une valeur dans une table dont l'adresse est déterminée par l'application ; le calcul peut aussi être un calcul à l'aide d'une formule sur laquelle on reviendra plus loin ; $Z_a = F1$ ("appli") où F1 est une première fonction de calcul définie par des moyens de programmation du processeur PRO ;
- attribution de la valeur ainsi calculée à l'impédance $Z_a$, par exemple sélection d'une ou plusieurs capacités dans un groupe de capacités commutables, ou réglage d'une tension d'une diode varactor ;
- calcul et attribution d'une valeur d'atténuation att, dans les cas où la chaîne travaille à puissance nominale variable en fonction de l'application ; att = F2("appli") où F2 est une fonction définie par les moyens de programmation du processeur ;
- calcul par le processeur du module et de l'argument de l'impédance Zm de la charge actuelle de l'amplificateur ; $Zm = Z_a.V/v_a$ ; il est à noter qu'on pourrait mesurer V en aval de la capacité $C_a$ plutôt

qu'en amont ; l'impédance Zm serait alors l'impédance en aval et les calculs ultérieurs doivent en tenir compte en considérant que l'impédance $Z_a$ fait partie de l'impédance de sortie de l'amplificateur de mesure plutôt que de la charge de l'amplificateur ;
- calcul à partir de là de l'impédance vectorielle Zm en partie réelle et partie imaginaire,
- calcul de l'impédance de l'antenne $Z_{ant}$, à partir de ces valeurs et des valeurs d'impédance actuelles connues des différentes impédances Z1, Z2, etc. qui constituent le réseau d'adaptation MN ; $Z_{ant} = F3(Zm, Z1, Z2, ...Z_a)$,
- calcul d'une ou plusieurs valeurs d'impédances modifiées Z'1, Z'2 du réseau d'adaptation MN à partir d'une valeur désirée $Z_{opt}$ de l'impédance de charge de l'amplificateur, de l'impédance de mesure $Z_a$, et de l'impédance d'antenne calculée $Z_{ant}$, et commande du réseau MN pour donner aux impédances Z1, Z2 de ce réseau les valeurs modifiées Z'1, Z'2 ainsi calculées. $Z'1, Z'2...= F4(Z_{ant}, Z_a, Z_{opt})$,
- commande de la chaîne à partir du circuit de contrôle CTRL pour donner aux impédances Z1, Z2 de ce réseau les valeurs modifiées Z'1, Z'2 ainsi calculées.

Calcul et choix de l'impédance de mesure $Z_a$

Les bases de ce calcul reposent sur les considérations suivantes :

a) il faut éviter de trop réduire le rendement du réseau d'adaptation MN, rendement qui diminue si l'impédance $Z_a$ augmente ; il faut donc une capacité $C_a$ suffisamment grande ;
b) mais une capacité trop grande est encombrante, elle est source de pertes, et elle ne permet pas de bien mesurer le rapport $V/v_a$ ($v_a$ étant trop faible) qui est nécessaire pour les calculs d'adaptation ; inversement d'ailleurs une capacité trop petite ferait que les variations d'impédance de charge dues aux variations d'impédance d'antenne n'entraîneraient que de faibles modifications du rapport $V/v_a$ même si $v_a$ est plus facile à mesurer, et on aboutirait aussi à une difficulté de calcul du réseau d'adaptation.

Du point de vue de la mesure à laquelle on se réfère dans le paragraphe b) précédent, on estime que la meilleure valeur de l'impédance de mesure est telle qu'elle soit proche en module de l'impédance de charge optimale de l'amplificateur et plutôt plus faible que cette dernière. Et du point de vue du rendement du réseau, on estime qu'il vaut mieux diminuer un peu cette valeur pour augmenter un peu le rendement.

Par conséquent, selon l'invention, une valeur préférée du module de l'impédance de mesure considérée comme purement capacitive est comprise entre $R_{opt}$ et $R_{opt}/4$ où $R_{opt}$ est le module de l'impédance de charge ou d'entrée optimale $Z_{opt}$. La capacité $C_a$ qui en résulte est de préférence comprise entre $1/\omega R_{opt}$ et $4/\omega R_{opt}$ ; $\omega$

est la pulsation $2\pi f$ de la fréquence de travail. Une valeur préférée est $C_a = 2/\omega R_{opt}$.

On peut prévoir qu'en fonction de la fréquence et de l'impédance de charge nominale fixée par l'application le processeur calcule une valeur optimale de capacité donnée par une formule telle que $C_a = k/\omega.R_{opt}$, k étant un nombre fixe compris entre 1 et 4 ; mais on peut prévoir aussi que le processeur sélectionne, en fonction de la fréquence et de l'impédance de charge nominale, une valeur dans une table de valeurs prédéfinies, calculées avec les formules ci-dessus. Le circuit de contrôle CTRL applique cette valeur à la capacité $C_a$.

Si on revient sur les raisons du choix d'une valeur préférée de la capacité de mesure $C_a$, on peut faire le raisonnement suivant :

Le coefficient de qualité Q d'un réseau d'adaptation, supposé placé entre d'un côté une résistance de source $R_S$ (partie réelle de l'impédance de l'amplificateur) et de l'autre une impédance de charge $R_{LD}$, est $Q = [(R_s/R_{LD}) -1)]^{1/2}$ lorsque le réseau est adapté. Ce coefficient de qualité est proportionnel à la fréquence et au rapport entre l'énergie moyenne stockée dans le réseau et les pertes moyennes dans le réseau.

Mais si la résistance de source $R_S$ est en série avec une impédance réactive $X_S$, il faut transformer cet ensemble série en un montage en parallèle d'une résistance $R_{PS}$ et d'une capacité $C_{PS}$, pour pouvoir appliquer la formule ci-dessus, la résistance $R_{PS}$ se substituant à la résistance $R_{PS}$ : $Q = [(R_{PS}/R_{LD}) - 1]^{1/2}$. Or les deux représentations série et parallèle correspondent à un même coefficient de qualité de l'impédance complexe, le coefficient de qualité étant le rapport entre la partie imaginaire et la partie réelle de l'impédance complexe, on peut montrer que :

- le coefficient de qualité est $O_S = X_S/R_S$ ou encore $Q_{PS} = R_{PS}/X_{PS}$
- $R_{PS} = R_S(+R_{PS}^2/X_{PS}^2)$ en raison des équations de transformations d'impédances séries en impédances parallèles
- $X_{PS} = X_S(1 +X_{PS}^2/R_{PS}^2)$ pour la même raison
- donc $R_{PS}= R_S(1+Q_S^2) = R_S[1+ 1/(R_S C_a\omega)^2]$ dans le cas d'une capacité $C_a$ en série avec $R_S$ en amont du réseau MN.

Le coefficient de qualité Q du réseau d'adaptation, défini par
$Q =[(R_{PS}/R_{LD}) -1]^{1/2}$ devient alors

$$Q = \sqrt{\frac{R_S * \left(1 + \frac{1}{(R_S \, C_a \, \omega)^2}\right)}{R_{LD}} - 1}$$

Le rendement du réseau d'adaptation (puissance transmise sur puissance perdue) dépend de ce coefficient de qualité Q ainsi que des coefficients de qualité individuels des éléments qui constituent le réseau. Si le réseau est un simple montage en $\Pi$ de deux capacités ayant des coefficients de qualité $Q_C$ individuels (partie imaginaire/partie réelle de l'admittance) et une inductance ayant un coefficient de qualité $Q_L$, on peut écrire que le rendement $\eta$ du réseau est ;

$$\eta = \frac{1 - \dfrac{2Q}{Q_C}}{1 + \dfrac{Q}{Q_L}}$$

Si on considère que le coefficient de qualité des capacités est très élevé, cela revient à écrire que

$$\eta = \frac{1}{1 + \dfrac{Q}{Q_L}}$$

Le rendement pour une valeur donnée de $Q_L$ (fixée principalement par la technologie de fabrication de l'inductance) dépend donc de Q ; il augmente lorsque Q diminue, donc lorsque la capacité $C_a$ augmente. On peut tracer une courbe de variation du rendement en fonction de la capacité $C_a$ pour une fréquence donnée, une valeur donnée de résistance de source $R_S$, une valeur de résistance de charge $R_{LD}$ et une valeur de coefficient de qualité d'inductance. On peut aussi calculer le rendement en présence d'une capacité $C_a$ infinie, c'est-à-dire lorsque l'amplificateur est relié directement au réseau, ce rendement étant d'autant plus fort que le coefficient de qualité de l'inductance est élevé. On peut alors imposer que le rendement en présence d'une capacité $C_a$ soit d'au moins 98% du rendement en l'absence de capacité de mesure. Cela fixe une valeur minimale de capacité $C_a$.

Mais cette valeur minimale doit rester compatible avec ce qui a été dit ci-dessus, à savoir que la capacité $C_a$ a de préférence une valeur égale à $k/\omega.R_{opt}$ où k est compris de préférence entre 1 et 4.

Si le coefficient de qualité $Q_L$ de l'inductance est faible, le rendement $\eta$ du réseau sera faible et il sera sans doute nécessaire de choisir k dans les valeurs les plus élevées (entre 2 et 4). Si le coefficient de qualité de l'inductance est meilleur, on pourra choisir un coefficient k plus faible, entre 1 et 2 (pour avoir une bonne efficacité de mesure en termes de valeur ni trop faible ni trop forte du rapport $V/v_a$ comme expliqué précédemment) tout en ayant un rendement d'au moins 98% du rendement en l'absence de capacité.

A titre d'exemple :

Les impédances de charge ou d'entrée optimales $R_{opt}$ sont typiquement de 50 ohms, 100 ohms, ou 200 ohms selon les applications. Les fréquences de travail sont typiquement de 403 MHz, 900 MHz, 2,44 GHz selon les applications. Il est facile de calculer une capacité de mesure, en supposant que le coefficient est k=2. Par exemple :

    C=15,8 pF pour 403 MHz à 50 ohms
    C=1,77 pF pour 900 MHz à 200 ohms
    C=1,30 pF pour 2,44 GHz à 100 ohms.

Si la capacité est différente de cette valeur il va de soi que le circuit fonctionne quand même. Typiquement, on peut imaginer que la capacité peut prendre des valeurs de 1 à 16 pF (obtenues par la mise en parallèle commutable de quatre capacités de valeurs respectives 1, 2, 4, et 8 pF) et dans ce cas, dans les trois exemples précédents on choisirait des valeurs de $C_a$ qui sont simplement 16 pF, 2 pF, et 1 pF respectivement. Le processeur calcule ensuite l'adaptation du réseau MN en utilisant les valeurs sélectionnées 16 pF, 2 pF, et 1 pF respectivement, et non pas les valeurs théoriques optimales 15,8 pF, 1,77 pF et 1,30 pF.

**Calcul d'adaptation du réseau MN**

Le calcul dépend bien entendu de la configuration du réseau d'adaptation MN et on va donner ci-après un exemple pour une configuration de réseau d'adaptation en Pi à trois impédances Z1, Z2, Z3 qui sont constituées par deux capacités variables en dérivation C1 et C2 séparées par une inductance L en série, de valeur fixe ; ce réseau est représenté à la figure 3.

On appellera C1 et C2 les valeurs actuelles des capacités du réseau d'adaptation et C1' et C2' les nouvelles valeurs de ces capacités, calculées pour optimiser l'impédance de charge de l'amplificateur en la rendant autant que possible égale à la valeur optimale $Z_{opt}$.

Première étape : calcul de l'impédance de charge actuelle

Les niveaux de tension V et $v_a$ ramenés à la fréquence intermédiaire ou en bande de base sont utilisés pour calculer le courant vectoriel i puis l'impédance complexe V/i vue par l'amplificateur (ou pour calculer directement cette impédance V/i sans passer par la détermination de i). Les déphasages sont conservés dans le changement de fréquence. On rappelle qu'on pourrait mesurer V aux bornes d'entrée du réseau en aval de la capacité $C_a$, à condition d'en tenir compte dans les calculs.

Le module de i est le rapport du module de $v_a$ et du module de l'impédance $Z_a = 1/j.C_a.\omega$ ; ou alternativement le module de l'impédance Z est le module du produit $V.Z_a/V_a$, c'est-à-dire du produit $V/j.C_a.\omega.v_a$. Le déphasage de i par rapport à la tension V est un angle $\theta$ qui représente l'argument de l'impédance Z. Cet angle peut être déterminé à partir du déphasage entre V et $v_a$ auquel on soustrait $\pi/2$ sachant que le déphasage entre i et $v_a$ est de $\pi/2$ puisque $Z_a$ est une capacité.

Le déphasage entre V et $v_a$ peut être calculé par exemple en multipliant les signaux analogiques V et $v_a$, ramenés en bande de base, et en observant la variation périodique du produit des deux signaux. Ce produit oscille entre une valeur maximum positive et une valeur minimum négative. La somme algébrique de ces deux valeurs est proportionnelle au cosinus du déphasage et le coefficient de proportionnalité est la différence algébrique de ces deux valeurs. Par conséquent, en faisant le rapport entre la somme des deux valeurs et la différence des deux valeurs on trouve le cosinus du déphasage dont on tire le déphasage entre V et $v_a$, d'où on déduit le déphasage entre V et i. D'autres méthodes de calcul numérique du déphasage peuvent être utilisées, par exemple par numérisation des deux signaux V et $v_a$ sur un bit, égal à 1 lorsque le signal est positif et à 0 lorsqu'il est négatif. Le décalage temporel des trains d'impulsions de bits 1 résultant de la numérisation de V, par rapport aux mêmes trains d'impulsions correspondant à la numérisation de $v_a$, représente le déphasage entre V et $v_a$. Le signe du déphasage est repéré en observant les fronts de montée des signaux ainsi numérisés sur un bit ; ceci peut se faire par une bascule D qui reçoit sur une entrée de signal l'une des tensions V ou $v_a$ et sur une entrée d'horloge l'autre de ces tensions, et qui reporte à sa sortie l'état de l'entrée de signal au moment d'un front de montée sur l'entrée d'horloge.

Une fois qu'on a l'argument $\theta$ de l'impédance Z, on peut calculer la partie réelle et la partie imaginaire de Z. On appellera Zm l'impédance ainsi mesurée pour Z ; Zmr est sa partie réelle, Zmi est sa partie imaginaire.

Zmr est égal au module de Z multiplié par $\cos\theta$.

Zmi est égal au module de Z multiplié par $\sin\theta$.

Deuxième étape : calcul de l'impédance actuelle de l'antenne

A partir de cette mesure de Z, connaissant la configuration du réseau d'adaptation qui est celle de la figure 3, avec les valeurs numériques actuelles connues des capacités C1 et C2 et de l'inductance L, et également la valeur numérique de la capacité $C_a$, on peut calculer l'impédance de l'antenne.

On n'exposera pas tout le détail du calcul mais seulement les étapes principales.

Si on écrit l'impédance $Z_{ant}$ de l'antenne sous la forme

$Z_{ant} = (A+jB)/(C+jD)$, on peut montrer que dans le schéma de la figure 3 :

$A = 1 - LC1\omega^2 - LC_a\omega^2 - Zmi.LC1C_a\omega^3 + Zmi.C_a\omega.$

$B = Zmr.LC1C_a\omega^3 - Zmr.C_a\omega.$

$C = Zmr.LC1C2C_a\omega^4 - Zmr.C1C_a\omega^2 - Zmr.C2C_a\omega^4.$

$D = Zmi.(LC1C2C_a\omega^4 - C1C_a\omega^2 - C2C_a\omega^2) + L\omega^3$
$(C1C2+C2C_a)-C1\omega - C2\omega - C_a\omega.$

On en déduit le module et l'argument de l'impédance d'antenne actuelle $Z_{ant}$ :

    le module de $Z_{ant}$ est la racine carrée de $(A^2+B^2)/(C^2+D^2)$.
    l'argument de $Z_{ant}$ est la différence entre l'arctangente de B/A et l'arctangente de D/C.

La partie réelle de $Z_{ant}$ est ZantR, égale au module multiplié par le cosinus de cet argument ; la partie imaginaire de $Z_{ant}$ est Zantim et est le module multiplié par le sinus de ce même argument.

On peut aussi calculer de la même manière l'admittance $Y_{ant}$ de l'antenne, en partie réelle YantR et en partie imaginaire Yantim.

$Z_{ant}$ et $Y_{ant}$ sont entièrement déterminables après le calcul de Zm.

Troisième étape : calcul de valeurs modifiées pour le réseau MN

Connaissant à la fois l'impédance actuelle de l'antenne et toutes les impédances du réseau d'adaptation (C1, C2, L) ainsi que la capacité $C_a$, on peut calculer maintenant les valeurs C'1, C'2, qu'il faut donner aux capacités C1 et C2 pour que l'impédance de l'ensemble, telle qu'elle sera vue aux bornes de l'amplificateur soit égale à la valeur nominale $Z_{opt}$ et non plus à la valeur Zm qu'on a déterminé précédemment. L'égalité parfaite n'étant pas possible, on cherchera à s'en approcher autant que possible, en tenant compte notamment du fait que la précision d'ajustement des capacités du réseau d'adaptation est limitée.

La méthode s'inspire des principes utilisés pour calculer des impédances par les abaques de Smith : on recherche quelles sont les valeurs d'impédance capacitives ou inductives mises en shunt ou en série qui déplacent l'impédance de charge sur l'abaque jusqu'à l'amener au centre de l'abaque, le centre représentant une impédance nominale. Les graduations de ces abaques étant normalisées, avec une impédance nominale unitaire au centre de l'abaque, on considère à chaque fois non pas les valeurs réelles d'impédances mais leurs valeurs normalisées, c'est-à-dire divisée par $Z_{opt}$. A la fin des calculs, pour retrouver les impédances vraies, on les multiplie par $Z_{opt}$.

Le calcul à partir des valeurs normalisées se déroule en plusieurs phases, et une manière particulièrement avantageuse de faire ce calcul est donnée ci-après. On notera que le mode de calcul d'adaptation des éléments d'un réseau qui va maintenant être exposé pourrait être utilisé dans n'importe quel contexte où on a besoin de faire une adaptation d'impédance connaissant l'impédance complexe en aval du réseau et l'impédance complexe en amont.

On n'exposera le principe de calcul que pour une chaîne d'émission (réseau d'adaptation placé en aval de l'amplificateur), la transposition étant évidente pour une chaîne de réception (réseau placé en amont de l'amplificateur).

On considère d'abord qu'une impédance de source normalisée complexe en série $R_s + jX_s$ (comprenant à la fois l'impédance de sortie de l'amplificateur et la capacité de mesure $C_a$) est placée en amont du réseau, et qu'une impédance complexe de charge en série $R_L + jX_L$ (l'impédance normalisée de l'antenne $Z_{ant}$ qu'on a calculée précédemment) est placée en aval (schéma de la figure 3).

On transforme ce schéma en un schéma équivalent dans lequel les impédances en amont et en aval sont transformées en montages d'admittances en parallèle $1/R_{PS}$ et $jC_{PS}$ du côté de la source, et $1/R_{PL}$ et $jC_{PL}$ du côté de la charge. Le schéma est celui de la figure 4.

Les équations qui permettent cette transformation sont connues et ont été évoquées plus haut. Si on appelle $Q_S$ et $Q_L$ les facteurs de qualité des impédances complexes en amont et en aval, $Q_S = -X_S/R_S$ et $Q_L = -X_L/R_L$, les équations de transformation série-parallèle donnent :

$$R_{PS} = R_S (1+Q_S^2) \text{ et } C_{PS} = Q_S/R_{PS}\omega$$

$R_{PS}$ et $C_{PS}$ peuvent être calculés puisqu'on connaît les impédances en amont.

De la même manière, on peut écrire les équations de transformation

$$R_{PL} = R_L (1+Q_L^2) \text{ et } C_{PL} = Q_L/R_{PL}\omega$$

La capacité $C_{PS}$ vient en parallèle avec la capacité C1 du réseau d'adaptation, et la capacité $C_{PL}$ vient en parallèle avec la capacité C2.

Le problème du calcul des capacités C1 et C2 pour adapter le réseau en présence d'impédances complexes de source et de charge est transformé en un problème plus simple de calcul d'un réseau d'adaptation placé entre deux impédances réelles $R_{PS}$ et $R_{PL}$ si on considère maintenant un réseau en $\Pi$ modifié avec deux capacités $C_{P1}$ et $C_{P2}$ et une inductance L, où $C_{P1} = C_{PS} + C1$, et $C_{P2} = C_{PL} + C2$ (schéma de la figure 5).

Le calcul de l'adaptation consiste alors à rechercher d'abord les nouvelles valeurs qu'il faut donner à $C_{P1}$ et $C_{P2}$ pour adapter l'impédance de charge à l'impédance de source, puis en déduire les valeurs C'1 et C'2 qu'il faut donner en substitution de C1 et C2.

Le principe de calcul est fondé sur l'analyse d'impédances par les abaques de Smith : on regarde par quelles successions d'admittances rajoutées en parallèle ou d'impédances rajoutées en série on peut passer d'une impédance de source réelle $R_{PS}$ au point P1 en amont du réseau à une impédance de charge réelle $R_{PL}$ au point P2 en aval.

En calcul normalisé, $R_{PS} = 1$. Si on ajoute l'admittance de la capacité $C_{P1}$ au point P1 d'entrée du réseau, et qu'on appelle x cette admittance, x étant une inconnue puisqu'on cherche $C_{P1}$ et x étant égal $jC_{P1}\omega$, l'admittance en ce point P1 est $y1(x) = 1 - j.x$. La partie réelle est $y1 r(x) = 1$ ; la partie imaginaire est $jy1i(x) = -jx$

Si on veut maintenant ajouter l'inductance pour en déduire la modification d'impédance qu'elle entraîne au point P2, il faut travailler en impédances et non en inductances car l'inductance est en série : il faut retrancher $-jL\omega$ à l'impédance $z1(x) = 1/y1(x)$. On obtient une impédance $z2(x) = [1/(1-j.x)] -jL\omega$ au point P2. On suppose qu'on néglige la composante résistive éventuelle de l'inductance, mais un calcul plus complet pourrait en tenir compte.

Cette impédance $z2(x)$ peut être convertie en une admittance $y2(x) = 1/z2(x) = 1/\{[1/(1-j.x)] -jL\omega\}$

L'adaptation du circuit est réalisée à la condition que cette admittance calculée $y2(x)$ soit égale à l'admittance réellement connectée, à savoir l'ensemble en parallèle de $C_{P2}$ et de la résistance $R_{PL}$.

La partie réelle $y2r(x)$ de l'admittance $y2(x)$ doit être égale à la partie réelle de l'admittance réellement connectée, à savoir $1/R_{PL}$.

De même, la partie imaginaire $y2i(x)$ de l'admittance $y2(x)$ doit être égale à $jC_{P2}\omega$.

L'égalité des parties réelles conduit à l'équation $(1-Lx \omega)^2 + L^2 \omega^2 = R_{PL}$, équation du deuxième degré en x qui admet deux solutions dont une seule est viable en pratique. La solution est $x_0 = \{1 + [R_{PL}-(L \omega)^2]^{1/2}\}/L\omega$

On en déduit la valeur de $C_{P1}$ : $C_{P1} = 1/x_0 \omega$

De la même manière, avec maintenant $x=x_0$, en réalisant l'égalité des parties imaginaires des admittances $y2(x_0) = 1/\{[1/(1-j.x_0)] -jL\omega\}$ et $jC_{P2}\omega$, on peut calculer $C_{P2}$.

Connaissant $C_{P1}$ et $C_{P2}$, on reprend les équations inverses qui permettent de remonter à C1 et C2. Les nouvelles valeurs C'1 et C'2 qu'il faut donner aux capacités du réseau d'adaptation sont :

$$C'1 = C_{P1} - Q_S/R_{PS}\omega$$

$$C'2 = C_{P2} - Q_L/R_{PL}\omega$$

Ce sont là les valeurs normalisées de C'1 et C'2. Il faut les diviser par le module de l'impédance de charge optimale $Z_{opt}$ pour avoir les valeurs réelles.

Le processeur effectue tous les calculs qui précèdent et commande le circuit de contrôle CTRL pour attribuer aux capacités du réseau les valeurs ainsi calculées.

On comprend que des calculs similaires peuvent être faits sur le même principe avec un réseau d'adaptation qui serait différent du réseau C1, C2, L de la figure 2, et également avec une impédance de mesure de courant qui serait différente de la capacité $C_a$.

**Revendications**

1. Procédé d'adaptation automatique d'impédance pour une chaîne d'émission radiofréquence comprenant au moins un amplificateur (PA), une antenne (ANT), un processeur de calcul (PRO), et un réseau d'adaptation d'impédance (MN) entre l'amplificateur et l'antenne, ce réseau comprenant plusieurs impédances dont certaines ont des valeurs numériques ajustables, l'amplificateur ayant une impédance de charge nominale ($Z_{opt}$) pour laquelle la chaîne a des performances désirées, et le procédé comprenant les étapes suivantes :

   - mesure du courant et de la tension de sortie de l'amplificateur,
   - calcul de l'impédance complexe (Zm) définie par le rapport entre cette tension et ce courant en tenant compte de leur déphasage, cette impédance représentant une impédance de charge actuelle de l'amplificateur,
   - calcul de l'impédance de l'antenne $Z_{ant}$ en fonction de cette impédance de charge actuelle et en fonction des valeurs actuelles connues des impédances ajustables du réseau d'adaptation,
   - calcul de nouvelles valeurs d'impédances ajustables du réseau d'adaptation qui permettent d'obtenir une impédance de charge globale de l'amplificateur aussi proche que possible de l'impédance de charge nominale, à partir de la valeur d'impédance d'antenne calculée,
   - commande du réseau d'adaptation pour ajuster les impédances ajustables à ces nouvelles valeurs,

   procédé **caractérisé en ce que** le courant est mesuré au moyen d'une impédance de mesure variable ($C_a$) placée en série entre la sortie de l'amplificateur et le réseau d'adaptation d'impédance, et cette impédance de mesure est commandée par le processeur en fonction de la fréquence de travail et de l'impédance de charge nominale de l'amplificateur.

2. Procédé d'adaptation automatique d'impédance pour une chaîne de réception radiofréquence comprenant au moins un amplificateur, une antenne, un processeur de calcul, et un réseau d'adaptation d'impédance entre l'antenne et l'amplificateur, ce réseau comprenant plusieurs impédances dont certaines ont des valeurs numériques ajustables, la chaîne de réception ayant des performances désirées lorsqu'une impédance d'entrée nominale est connectée à l'entrée de l'amplificateur, le procédé comprenant les étapes suivantes :

- mesure du courant et de la tension en entrée de l'amplificateur,
- calcul de l'impédance complexe définie par le rapport entre cette tension et ce courant en tenant compte de leur déphasage, cette impédance représentant une impédance d'entrée actuellement connectée à l'amplificateur,
- calcul de l'impédance de l'antenne en fonction de cette impédance d'entrée actuelle et en fonction des valeurs actuelles connues des impédances ajustables du réseau d'adaptation,
- calcul de nouvelles valeurs d'impédances ajustables du réseau d'adaptation qui permettent d'obtenir une impédance d'entrée globale de l'amplificateur aussi proche que possible de l'impédance d'entrée nominale, à partir de la valeur d'impédance d'antenne calculée,
- commande du réseau d'adaptation pour ajuster les impédances ajustables à ces nouvelles valeurs,

procédé **caractérisé en ce que** le courant est mesuré au moyen d'une impédance de mesure variable placée en série entre le réseau d'adaptation d'impédance et l'amplificateur, et cette impédance de mesure est commandée par le processeur en fonction de la fréquence de travail et de l'impédance d'entrée nominale de l'amplificateur.

**3.** Procédé d'adaptation automatique d'impédance selon l'une des revendications 1 et 2, **caractérisé en ce que** l'impédance de mesure est une capacité variable de valeur commandable par le processeur.

**4.** Procédé d'adaptation automatique d'impédance selon l'une des revendications 1 à 3, **caractérisé en ce qu'**il comprend l'élaboration d'une tension électrique de commande, pour commander l'ajustement de l'impédance de mesure en fonction de la valeur calculée.

**5.** Procédé d'adaptation automatique d'impédance selon l'une des revendications 1 à 3, **caractérisé en ce qu'**il comprend l'élaboration de signaux de commande de commutation à partir du résultat du calcul d'une nouvelle valeur d'impédance ajustable, et l'application de ces signaux à un réseau de capacités élémentaires commutables, constituant l'impédance de mesure.

**6.** Procédé selon la revendication 3, **caractérisé en ce que** le processeur calcule et applique une valeur de capacité qui est comprise entre 1 fois et 4 fois le rapport $1/Z_{opt}\omega$, où $Z_{opt}$ est l'impédance nominale de

la chaîne, et $\omega$ est $2\pi f$, f étant la fréquence de travail désirée pour la chaîne.

**7.** Procédé selon l'une des revendications 1 à 6, **caractérisé en ce que** le réseau d'adaptation est un réseau en Pi comprenant une admittance réactive d'entrée, une impédance réactive de liaison, et une admittance réactive de sortie, et le calcul des éléments de ce réseau d'adaptation comprend successivement un calcul de partie réelle y2r et partie imaginaire y2i d'une admittance y2 qui est l'inverse de l'impédance ($Z_{ant}$) de l'antenne, un calcul de partie réelle y1r et partie imaginaire y1i d'une admittance y1 qui est l'inverse de l'impédance de l'ensemble en série de l'impédance de sortie de l'amplificateur et de l'impédance de mesure, un calcul d'un réseau fictif comprenant un montage en Pi d'une admittance réactive d'entrée, d'une admittance réactive de sortie, et d'une impédance réactive de liaison égale à celle du réseau réel, ce montage en Pi étant placé entre deux admittances réelles qui sont les parties réelles y1r et y2r, et le calcul étant une détermination des admittances réactives d'entrée et de sortie qu'il faut dans le réseau fictif pour adapter l'impédance de ce réseau chargé par y2r à l'impédance d'entrée réelle y1 r, et enfin, après calcul des admittances réactives d'entrée et de sortie du réseau fictif, une détermination d'admittances du réseau d'adaptation de la manière suivante :

- l'admittance réactive d'entrée est la différence entre l'admittance d'entrée du réseau fictif et la partie imaginaire y1i,
- l'admittance réactive de sortie est la différence entre l'admittance de sortie du réseau fictif et la partie imaginaire y2i,
- l'impédance réactive de liaison est celle du réseau fictif.

**8.** Chaîne d'émission ou de réception radiofréquence comportant au moins un amplificateur (PA), une antenne (ANT), un processeur de calcul (PRO), et un réseau d'adaptation d'impédance (MN) entre l'amplificateur et l'antenne, ce réseau comprenant plusieurs impédances (C1, C2) dont certaines ont des valeurs numériques ajustables, la chaîne comportant :

- une impédance de mesure ($C_a$) insérée en série entre l'amplificateur et le réseau d'adaptation,
- des moyens de mesure d'une première tension qui est la tension aux bornes de l'impédance de mesure et d'une deuxième tension qui est la tension en sortie de l'amplificateur, pour une chaîne d'émission, ou la tension en entrée de l'amplificateur, pour une chaîne de réception,
- des premiers moyens de programmation du processeur de calcul pour calculer l'impédance complexe de charge ou d'entrée actuelle de l'amplificateur à partir du rapport entre la deuxième tension et la première tension, en tenant compte du déphasage entre ces tensions,

- des deuxièmes moyens de programmation du processeur de calcul pour calculer l'impédance de l'antenne en fonction de cette impédance de charge ou d'entrée actuelle et en fonction des valeurs actuelles connues des impédances ajustables du réseau d'adaptation,

- des troisièmes moyens de programmation du processeur de calcul pour calculer des nouvelles valeurs d'impédance ajustables du réseau d'adaptation qui permettent d'obtenir une impédance de charge ou d'entrée globale de l'amplificateur aussi proche que possible d'une impédance de charge ou d'entrée nominale de l'amplificateur, à partir de la valeur d'impédance d'antenne calculée,

- des moyens de commande électrique du réseau d'adaptation pour ajuster les impédances ajustables à ces nouvelles valeurs,

**caractérisée en ce que** l'impédance de mesure est une impédance complexe variable, le processeur de calcul comprend des moyens pour sélectionner une valeur souhaitée pour l'impédance de mesure, en fonction de la fréquence de travail souhaitée et de la valeur de l'impédance de charge ou d'entrée nominale de l'amplificateur et la chaîne comprend des moyens pour attribuer cette valeur sélectionnée à l'impédance de mesure.

9. Chaîne d'émission ou réception radiofréquence selon la revendication 8, **caractérisée en ce que** l'impédance de mesure est une capacité variable ($C_a$) de valeur commandable par le processeur.

10. Chaîne d'émission ou réception radiofréquence selon l'une des revendications 8 et 9, **caractérisée en ce que** le réseau d'adaptation comprend un montage en Té ou en Pi de trois éléments réactifs (L, C1, C2).

11. Chaîne d'émission ou réception radiofréquence selon l'une des revendications 9 et 10, **caractérisée en ce que** le processeur est adapté pour calculer et appliquer une valeur de capacité qui est comprise entre 1 fois et 4 fois le rapport $1/Z_{opt}\omega$, où $Z_{opt}$ est l'impédance nominale de la chaîne, et $\omega$ est $2\pi f$, f étant la fréquence de travail désirée pour la chaîne.

**Patentansprüche**

1. Verfahren zur automatischen Impedanzanpassung für eine Funkfrequenzsendekette, die wenigstens einen Verstärker (PA), einen Antenne (ANT), einen Rechenprozessor (PRO) und ein Impedanzanpassungsnetz (MN) zwischen dem Verstärker und der Antenne umfasst, wobei dieses Netz mehrere Impedanzglieder aufweist, von denen einige einstellbare digitale Werte haben, wobei der Verstärker eine Nennladungsimpedanz ($Z_{opt}$) hat, für die die Kette gewünschte Leistungen hat, und wobei das Verfahren die folgenden Schritte beinhaltet:

- Messen des Stroms und der Spannung am Ausgang des Verstärkers,
- Berechnen der komplexen Impedanz (Zm), definiert durch das Verhältnis zwischen dieser Spannung und diesem Strom unter Berücksichtigung ihres Phasenversatzes, wobei diese Impedanz eine Ist-Ladungsimpedanz des Verstärkers repräsentiert,
- Berechnen der Impedanz der Antenne $Z_{ant}$ in Abhängigkeit von dieser Ist-Ladungsimpedanz und in Abhängigkeit von bekannten Ist-Werten der einstellbaren Impedanzen des Anpassungsnetzes,
- Berechnen von neuen einstellbaren Impedanzwerten des Anpassungsnetzes, so dass eine globale Ladungsimpedanz des Verstärkers so nahe wie möglich an der Nennladungsimpedanz erhalten werden kann, auf der Basis des berechneten Antennenimpedanzwertes,
- Steuern des Anpassungsnetzes zum Einstellen der einstellbaren Impedanzen auf diese neuen Werte,

wobei das Verfahren **dadurch gekennzeichnet ist, dass** der Strom mittels eines variablen Messimpedanzglieds ($C_a$) gemessen wird, das in Serie zwischen dem Ausgang des Verstärkers und dem Impedanzanpassungsnetz geschaltet ist, und dieses Messimpedanzglied vom Prozessor in Abhängigkeit von der Arbeitsfrequenz und der Nennladungsimpedanz des Verstärkers gesteuert wird.

2. Verfahren zur automatischen Impedanzanpassung für eine Funkfrequenzempfangskette, die wenigstens einen Verstärker, eine Antenne, einen Rechenprozessor und ein Impedanzanpassungsnetz zwischen der Antenne und dem Verstärker umfasst, wobei dieses Netz mehrere Impedanzglieder aufweist, von denen einige einstellbare digitale Werte haben, wobei die Empfangskette gewünschte Leistungen hat, wenn die Nenneingangsimpedanz mit dem Eingang des Verstärkers verbunden ist, wobei das Verfahren die folgenden Schritte beinhaltet:

- Messen des Stroms und der Spannung am Eingang des Verstärkers,
- Berechnen der komplexen Impedanz, definiert durch das Verhältnis zwischen dieser Spannung und diesem Strom unter Berücksichtigung ihres Phasenversatzes, wobei diese Impedanz eine mit dem Verstärker verbundene Ist-Eingangsimpedanz repräsentiert,

- Berechnen der Impedanz der Antenne in Abhängigkeit von dieser Ist-Eingangsimpedanz und in Abhängigkeit von bekannten Ist-Werten der einstellbaren Impedanzen des Anpassungsnetzes,

- Berechnen von neuen einstellbaren Impedanzwerten des Anpassungsnetzes, so dass eine globale Eingangsimpedanz des Verstärkers so nahe wie möglich an der Nenneingangsimpedanz erhalten werden kann, auf der Basis des berechneten Antennenimpedanzwertes,

- Steuern des Anpassungsnetzes zum Einstellen der einstellbaren Impedanzen auf diese neuen Werte,

wobei das Verfahren **dadurch gekennzeichnet ist, dass** der Strom mittels eines variablen Messimpedanzglieds gemessen wird, das in Serie zwischen dem Impedanzanpassungsnetz und dem Verstärker geschaltet ist, und dieses Messimpedanzglied vom Prozessor in Abhängigkeit von der Arbeitsfrequenz und der Nenneingangsimpedanz des Verstärkers gesteuert wird.

3. Verfahren zur automatischen Impedanzanpassung nach einem der Ansprüche 1 und 2, **dadurch gekennzeichnet, dass** das Messimpedanzglied ein variables Kapazitätsglied mit einem vom Prozessor regelbaren Wert ist.

4. Verfahren zur automatischen Impedanzanpassung nach einem der Ansprüche 1 bis 3, **dadurch gekennzeichnet, dass** es die Ausarbeitung einer elektrischen Steuerspannung zum Steuern der Einstellung des Messimpedanzglieds in Abhängigkeit von dem berechneten Wert umfasst.

5. Verfahren zur automatischen Impedanzanpassung nach einem der Ansprüche 1 bis 3, **dadurch gekennzeichnet, dass** es die Ausarbeitung von Schaltsteuersignalen auf der Basis des Ergebnisses der Berechnung eines neuen einstellbaren Impedanzwertes und das Anlegen dieser Signale an ein Netz von schaltbaren elementaren Kapazitätsgliedern beinhaltet, die das Messimpedanzglied bilden.

6. Verfahren nach Anspruch 3, **dadurch gekennzeichnet, dass** der Prozessor einen Kapazitätswert berechnet und anwendet, der zwischen dem 1-fachen und dem 4-fachen des Verhältnisses von $1/Z_{opt}\omega$ liegt, wobei $Z_{opt}$ die Nennimpedanz der Kette ist und $\omega$ $2\pi f$ ist, wobei f die gewünschte Arbeitsfrequenz für die Kette ist.

7. Verfahren nach einem der Ansprüche 1 bis 6, **dadurch gekennzeichnet, dass** das Anpassungsnetz ein Pi-Netz mit einem reaktiven Eingangsleitwert, einer reaktiven Verbindungsimpedanz und einem reaktiven Ausgangsleitwert ist und das Berechnen der Elemente dieses Anpassungsnetzes nacheinander Folgendes beinhaltet: eine Berechnung des Realteils y2r und des Imaginärteils y2i eines Leitwerts y2, der die Umkehr der Impedanz ($Z_{ant}$) der Antenne ist, eine Berechnung des Realteils y1r und des Imaginärteils y1i eines Leitwerts y1, der die Umkehr der Impedanz der Baugruppe in Serie mit der Ausgangsimpedanz des Verstärkers und des Messimpedanzglieds ist, eine Berechnung eines fiktiven Netzes, das eine Pi-Schaltung eines reaktiven Eingangsleitwerts, eines reaktiven Ausgangsleitwertes und einer reaktiven Verbindungsimpedanz von gleich der des realen Netzes ist, wobei diese Pi-Schaltung zwischen zwei reale Leitwerte geschaltet wird, die die Realteile y1r und y2r sind, und wobei die Berechnung eine Ermittlung von reaktiven Ein- und Ausgangsleitwerten ist, die in dem fiktiven Netz notwendig sind, um die Impedanz dieses durch y2r geladenen Netzes an die reale Eingangsimpedanz y1r anzupassen, und schließlich, nach dem Berechnen von reaktiven Eingangsleitwerten und Ausgangsleitwerten des fiktiven Netzes, Ermitteln von Leitwerten des Anpassungsnetzes auf die folgende Weise:

- der reaktive Eingangsleitwert ist die Differenz zwischen dem Eingangsleitwert des fiktiven Netzes und dem Imaginärteil y1i,
- der reaktive Ausgangsleitwert ist die Differenz zwischen dem Ausgangsleitwert des fiktiven Netzes und dem Imaginärteil y2i,
- die reaktive Verbindungsimpedanz ist die des fiktiven Netzes.

8. Funkfrequenzsende- oder -empfangskette, die wenigstens einen Verstärker (PA), eine Antenne (ANT), einen Rechenprozessor (PRO) und ein Impedanzanpassungsnetz (MN) zwischen dem Verstärker und der Antenne umfasst, wobei dieses Netz mehrere Impedanzglieder (C1, C2) aufweist, von denen bestimmte einstellbare digitale Werte haben, wobei die Kette Folgendes umfasst:

- ein Messimpedanzglied ($C_a$) in Serie zwischen dem Verstärker und dem Anpassungsnetz geschaltet,
- Mittel zum Messen einer ersten Spannung, die die Spannung an den Anschlüssen des Messimpedanzglieds ist, und einer zweiten Spannung, die für eine Sendekette die Spannung am Ausgang des Verstärkers oder für eine Empfangskette die Spannung am Eingang des Verstärkers ist,
- erste Mittel zum Programmieren des Rechenprozessors zum Berechnen der komplexen Ladungs- oder Ist-Eingangsimpedanz des Verstärkers auf der Basis des Verhältnisses zwischen der zweiten Spannung und der ersten Spannung unter Berücksichtigung des Phasenversatzes zwischen diesen Spannungen,
- zweite Mittel zum Programmieren des Rechenprozessors zum Berechnen der Impedanz der Antenne in Abhängigkeit von dieser Ladungs- oder Ist-Eingangsimpedanz und in Abhängigkeit von bekannten Ist-Werten von einstellbaren Impedanzen des Anpassungsnetzes,
- dritte Mittel zum Programmieren des Rechenprozessors zum Berechnen von einstellbaren neuen Impedanzwerten des Anpassungsnetzes, die es zulassen, eine globale Ladungs- oder Eingangsimpedanz des Verstärkers so nahe wie möglich an einer Ladungs- oder Nenneingangsimpedanz des Verstärkers zu erhalten, auf der Basis des berechneten Antennenimpedanzwertes,
- Mittel zum elektrischen Steuern des Anpassungsnetzes zum Einstellen der einstellbaren Impedanzen auf diese neuen Werte,

**dadurch gekennzeichnet, dass** die Messimpedanz eine variable komplexe Impedanz ist, der Rechenprozessor Mittel zum Wählen eines gewünschten Wertes für die Messimpedanz in Abhängigkeit von der gewünschten Arbeitsfrequenz und dem Wert der Ladungs- oder Nenneingangsimpedanz des Verstärkers umfasst, und die Kette Mittel zum Assoziieren dieses gewählten Wertes mit der Messimpedanz umfasst.

9. Funkfrequenzsende- oder -empfangskette nach Anspruch 8, **dadurch gekennzeichnet, dass** das Messimpedanzglied ein variables Kapazitätsglied ($C_a$) mit einem vom Prozessor regelbaren Wert ist.

10. Funkfrequenzsende- oder -empfangskette nach einem der Ansprüche 8 und 9, **dadurch gekennzeichnet, dass** das Anpassungsnetz eine T- oder eine Pi-Schaltung von drei reaktiven Elemente (L, C1, C2) umfasst.

11. Funkfrequenzsende- oder -empfangskette nach einem der Ansprüche 9 und 10, **dadurch gekennzeichnet, dass** der Prozessor zum Berechnen und Anwenden eines Kapazitätswertes ausgelegt ist, der zwischen dem 1-fachen und dem 4-fachen des Verhältnisses $1/Z_{opt}\omega$ liegt, wobei $Z_{opt}$ die Nennimpedanz der Kette ist und $\omega$ $2\pi f$ ist, wobei f die gewünschte Arbeitsfrequenz für die Kette ist.

**Claims**

1. An automatic impedance matching method for a radiofrequency transmission channel comprising at least one amplifier (PA), an antenna (ANT), a calculation processor (PRO), and an impedance matching network (MN) between the amplifier and the antenna, this network comprising several impedances some of which have adjustable numerical values, the amplifier having a nominal load impedance ($Z_{opt}$) for which the channel has the desired performance, and the method comprising the following steps:

- measurement of the output current and voltage of the amplifier,
- calculation of the complex impedance (Zm) defined by the ratio between this voltage and this current taking into account their phase difference, this impedance representing a current load impedance of the amplifier,
- calculation of the impedance of the antenna $Z_{ant}$ as a function of this current load impedance and as a function of the known current values of the adjustable impedances of the matching network,
- calculation of new values for the adjustable impedances of the matching network which allow an overall load impedance of the amplifier to be obtained as close as possible to the nominal load impedance, based on the calculated value of antenna impedance,
- control of the matching network for adjusting the adjustable impedances to these new values,

the method being **characterized in that** the current is measured by means of a variable measurement impedance ($C_a$) placed in series between the output of the amplifier and the impedance matching network, and this measurement impedance is controlled by the processor as a function of the operating frequency and of the nominal load impedance of the amplifier.

2. The automatic impedance matching method for a radiofrequency receiver channel comprising at least one amplifier, an antenna, a calculation processor, and an impedance matching network between the antenna and the amplifier, this network comprising several impedances some of which have adjustable numerical values, the receiver channel having the desired performance when a nominal input impedance is connected to the input of the amplifier, the method comprising the following steps:

- measurement of the input current and voltage of the amplifier,
- calculation of the complex impedance defined by the ratio between this voltage and this current taking into account their phase difference, this impedance representing an input impedance currently connected to the amplifier,
- calculation of the impedance of the antenna as a function of this current input impedance and as a function of the known current values of the adjustable impedances of the matching network,
- calculation of new values for the adjustable impedances of the matching network which allow an overall input impedance of the amplifier to be obtained as close as possible to the nominal input impedance, based on the calculated value of antenna impedance,
- control of the matching network for adjusting the adjustable impedances to these new values,

the method being **characterized in that** the current is measured by means of a variable measurement impedance placed in series between the impedance matching network and the amplifier, and this measurement impedance is controlled by the processor as a function of the operating frequency and of the nominal input impedance of the amplifier.

3. The automatic impedance matching method as claimed in either of claims 1 and 2, **characterized in that** the measurement impedance is a variable capacitor having a value which is controllable by the processor.

4. The automatic impedance matching method as claimed in one of claims 1 to 3, **characterized in that** it comprises the generation of an electrical control voltage for controlling the adjustment of the measurement impedance as a function of the calculated value.

5. The automatic impedance matching method as claimed in one of claims 1 to 3, **characterized in that** it comprises the generation of switching control signals based on the result of the calculation of a new adjustable value of impedance, and the application of these signals to a network of switchable elementary capacitors constituting the measurement impedance.

6. The method as claimed in claim 3, **characterized in that** the processor calculates and applies a capacitor value which is included in the range between 1 times and 4 times the ratio $1/Z_{opt}\omega$, where $Z_{opt}$ is the nominal impedance of the channel, and $\omega$ is $2\pi f$, f being the desired operating frequency for the channel.

7. The method as claimed in one of claims 1 to 6, **characterized in that** the matching network is a Pi network comprising an input reactive impedance, a link reactive impedance, and an output reactive impedance, and the calculation of the elements of this matching network comprises, successively, a calculation of a real part y2r and an imaginary part y2i of an admittance y2 which is the inverse of the impedance ($Z_{ant}$) of the antenna, a calculation of a real part y1r and an imaginary part y1i of an admittance y1 which is the inverse of the impedance of the series assembly of the output impedance of the amplifier and the measurement impedance, a calculation of a equivalent network comprising a Pi configuration of an input reactive impedance, an output reactive impedance, and a link reactive impedance equal to that of the real network, this Pi configuration being placed between two real admittances which are the real parts y1 r and y2r, and the calculation being a determination of the input and output reactive admittances that are needed in the equivalent network in order to match the impedance of this network loaded by y2r to the real input impedance y1 r, and finally, after calculation of the input and output reactive admittances of the equivalent network, a determination of admittances of the matching network in the following manner:

- the input reactive admittance is the difference between the input admittance of the equivalent network and the imaginary part y1 i,
- the output reactive impedance is the difference between the output admittance of the equivalent network and the imaginary part y2i,
- the link reactive impedance is that of the equivalent network.

8. A radiofrequency transmission or receiver channel comprising at least one amplifier (PA), an antenna (ANT), a calculation processor (PRO), and an impedance matching network (MN) between the amplifier and the antenna, this network comprising several impedances (C1, C2) some of which have adjustable numerical values, the channel comprising:

- a measurement impedance ($C_a$) inserted in series between the amplifier and the matching network,
- means for measuring a first voltage which is the voltage across the terminals of the measurement impedance and a second voltage which is the voltage at the output of the amplifier for a transmission channel or the voltage at the input of the amplifier for a receiver channel,
- first means for programming the calculation processor for calculating the current complex load or input impedance of the amplifier based on the ratio between the second voltage and the first voltage, taking into account the phase difference between these voltages,
- second means for programming the calculation processor for calculating the impedance of the antenna as a function of this current load or input impedance and as a function of the known current values of the adjustable impedances of the matching network,

- third means for programming the calculation processor for calculating new adjustable values of impedance for the matching network which allow an overall load or input impedance of the amplifier to be obtained as close as possible to a nominal load or input impedance of the amplifier, based on the calculated value of antenna impedance,

- electrical means for controlling the matching network for adjusting the adjustable impedances to these new values,

**characterized in that** the measurement impedance is a variable complex impedance, the calculation processor comprises means for selecting a desired value of the measurement impedance as a function of the desired operating frequency and of the value of the nominal load or input impedance of the amplifier, and the channel comprises means for assigning this selected value to the measurement impedance.

9. The radiofrequency transmission or receiver channel as claimed in claim 8, **characterized in that** the measurement impedance is a variable capacitor ($C_a$) having a value which is controllable by the processor.

10. The radiofrequency transmission or receiver channel as claimed in either of claims 8 and 9, **characterized in that** the matching network comprises a T or Pi configuration of three reactive elements (L, C1, C2).

11. The radiofrequency transmission or receiver channel as claimed in either of claims 9 and 10, **characterized in that** the processor is adapted to compute and apply a capacitor value which is comprised between 1 and 4 times the ratio $1/Z_{opt}\omega$, where $Z_{opt}$ is the nominal impedance of the amplifier and $\omega$ is $2\pi f$, f being the desired working frequency for the channel.

Fig. 1

**Fig. 2**

Détermination de capacité $C_a$ et atténuation en fonction de l'application

↓

Application à la capacité de mesure et à l'atténuateur

↓

Mesure de V et $v_a$

↓

Calcul de Zm $= Z_a V/v_a$ partie réelle et partie imaginaire

↓

Calcul de l'impédance d'antenne $Z_{ant} = F(Zm, Z1, Z2, ..., Z_a)$

↓

Calcul de Z'1, Z'2 .. $= F(Z_{ant}, Z_a, Z_{opt})$

↓

Application des valeurs Z'1, Z'2, ... au réseau d'adaptation MN

**Fig. 3**

$R_S + j.X_S$ (PA et $C_a$)   MN   L   C1   C2   $R_L + j.X_L$ ($Z_{ant}$)

**Fig. 4**

$R_{PS}$   $C_{PS}$   C1   L   C2   $C_{PL}$   $R_{PL}$

**Fig. 5**

P1   L   P2   $R_{PS}$   $C_{P1}$   $C_{P2}$   $R_{PL}$

$C_{P1} = C1 + C_{PS}$   $C_{P2} = C2 + C_{PL}$

EP 2 476 209 B1

**EP 2 476 209 B1**

## RÉFÉRENCES CITÉES DANS LA DESCRIPTION

**Documents brevets cités dans la description**

- US 4375051 A
- US 20090066440 A